# EUROPÄISCHE PATENTANMELDUNG

(11) **EP 1 120 914 A1**
(43) Veröffentlichungstag der Anmeldung: **01.08.2001**
(21) Anmeldenummer: 00128180.7
(22) Anmeldetag: 21.12.2000
(51) Int. Cl.: H03K 5/1534, H03K 5/13, H03K 5/06

(54) **Impulserzeuger**

(30) Priorität: 11.01.2000 DE 10000758
(71) Anmelder: Infineon Technologies AG, 81669 München (DE)
(72) Erfinder: Kuhne, Sebastian, 81249 München (DE)
(74) Vertreter: MÜLLER & HOFFMANN Patentanwälte

(57) **Zusammenfassung**

Die Erfindung betrifft eine Impulserzeugerschaltung, insbesondere zur Verwendung in bzw. für integrierte(n) Schaltungen, die in üblicher Weise eine ungerade Anzahl von in Reihe geschalteten Invertiergliedern (11, 15, 17) ein logisches Verknüpfungsglied (16) und ein Verzögerungsglied (12) aufweist. Eine erfindungsgemäß vorgesehene Zwischenspeicherschaltung (13,14) sorgt dafür, dass auch bei einem Eingangssignal (A) sehr kurzer Dauer eine minimale Impulsdauer des auf das Eingangssignal (A) erzeugten Ausgangsimpulses (0) garantiert ist.

## Beschreibung

Die Erfindung betrifft einen Impulserzeuger nach dem Oberbegriff des Patentanspruches 1.

Zur impulsförmigen Ansteuerung integrierter Schaltungen, z. B. von DRAMs, sind Eingangsimpulse gefordert, die eine definierte minimale Impulsdauer haben. Dabei tritt häufig das Problem auf, dass die Impulsdauer eines mit herkömmlichen Impulserzeugerschaltungen aus einem sehr kurzen Eingangssignal abgeleiteten Ausgangsimpulses nicht mit der gewünschten Sicherheit und Stabilität erzeugt werden kann.

Mit einer herkömmlichen Impulserzeugerschaltung lässt sich aus einem durch eine Vorderflanke dargestellten Eingangssignal ein Ausgangsimpuls mit einer garantierten maximalen Impulsdauer erzeugen. Diese Impulserzeugerschaltung enthält ein NAND-Glied, das zwei Eingänge aufweist, wobei dem einen Eingang das Eingangssignal unverzögert und dem anderen Eingang ein durch ein Verzögerungsglied verzögertes Eingangssignal zugeführt wird. Der Ausgang des NAND-Glieds geht tief, wenn der Zustand beider Eingangssignale des NAND-Glieds hoch ist, d. h. erst, wenn der das Eingangssignal darstellende Potenzialwechsel von tief nach hoch durch das Verzögerungsglied verzögert auch am zweiten Eingang des NAND-Glieds angelangt ist. Nach Inversion durch ein Invertierglied wird ein impulsförmiges Ausgangssignal am Ausgangsanschluss abgegeben, dessen Impulsdauer von der Verzögerungszeit des Verzögerungsglieds bestimmt ist. Die Erzeugung des Ausgangsimpulses ist jedoch dann nicht möglich oder undefiniert, wenn ein Eingangssignal in kürzerer Zeit als die Verzögerungszeit des Verzögerungsglieds wieder abklingt, da dann zu dem Zeitpunkt, in dem der zweite Eingang des NAND-Glieds hoch geht, das Potenzial am ersten Eingang des NAND-Glieds schon wieder tief gegangen ist.

In der DE 21 37 068 B2 ist eine Schaltungsanordnung zum Unterdrücken von Störimpulsen beschrieben, bei der ein Eingang über eine direkte Verbindung zu einem Rückstelleingang einer bistabilen Kippschaltung bzw. zu einer zeitbestimmenden Stufe führt. Die bistabile Kippstufe ist aus ersten NAND-Gliedern aufgebaut. Die zeitbestimmende Stufe enthält einen Hochpass mit einer nachgeschalteten invertierenden, potenzialgesteuerten Kippschaltung, welche durch ein zweites NAND-Glied gebildet wird. Dieser Schaltungsanordnung ist insgesamt ein weiteres NAND-Glied vorgeschaltet, um invertierte Eingangsimpulse zu verarbeiten. Die ersten NAND-Glieder sind kreuzgekoppelt, und ein Ausgangssignal enthält nur noch denjenigen Anteil eines Nutzimpulses eines Eingangssignales, welcher eine maximale Unterdrückzeit überschreitet.

Weiterhin ist aus der JP 0059161912 A eine Impulsgeneratorschaltung bekannt, bei der ein Eingangssignal zu einem Verzögerungsglied gespeist und ein Ausgangssignal durch eine Wählschaltung in einem Arbeitsmodus gewählt wird. Sodann wird das umgekehrte Signal des Eingangssignals zu einem UND-Glied geliefert, welches einen Taktimpuls abgibt. Ein weiteres Signal, das durch ein zusätzliches Verzögerungsglied in einem Testmodus geschickt ist, wird durch die Wählschaltung gewählt. Somit wird ein breiter Taktimpuls gewonnen und die Dauer der Signalübertragungszeit zwischen Verriegelungsgliedern wird überprüft.

Schließlich ist aus der DE 28 07 409 A1 eine Schaltungsanordnung zur Auskopplung von Impulsen bekannt, bei der NOR-Glieder für eine Zwischenspeicherung verwendet werden.

Es ist Aufgabe der vorliegenden Erfindung, die oben beschriebene und bei der herkömmlichen Impulserzeugerschaltung auftretende Schwierigkeit zu vermeiden und eine verbesserte und einfache Impulserzeugerschaltung anzugeben, die sich insbesondere zur Anwendung in bzw. für integrierte(n) Schaltungen eignet und die auch bei sehr kurz dauernden Eingangssignalen einen Ausgangsimpuls mit definierter minimaler Impulsdauer erzeugen kann.

Diese Aufgabe wird bei einem Impulserzeuger der eingangs genannten Art erfindungsgemäß durch die im kennzeichnenden Teil des Patentanspruches 1 angegebenen Merkmale gelöst.

Vorteilhafte Weiterbildungen der Erfindung ergeben sich aus den Unteransprüchen.

Die Zwischenspeicherschaltung, die in besonders einfacher Weise durch zwei kreuzgekoppelte NAND-Glieder realisiert werden kann, garantiert, dass ein hier beispielhaft durch einen Signalwechsel von tief nach hoch dargestelltes Eingangssignal A, das zunächst unmittelbar, d. h. im Wesentlichen unverzögert zum Ausgangsanschluss übertragen wird, gleichzeitig in der Zwischenspeicherschaltung zwischengespeichert wird.

Der in der Zwischenspeicherschaltung zwischengespeicherte Hoch-Zustand definiert den Impuls des Ausgangssignals, d. h. dessen minimale Impulsdauer. Die Zwischenspeicherung in der Zwischenspeicherschaltung wird gelöscht, wenn sich der Wechsel des Eingangssignals von tief nach hoch durch die Inverterkette fortgepflanzt hat. Dann ist für die Definition des Ausgangsimpulses wieder ausschließlich das Eingangssignal verantwortlich.

Für die Funktion der vorgeschlagenen Impulserzeugerschaltung ist lediglich Voraussetzung, dass die Dauer des Eingangssignals länger ist als die Zeitdauer, die auf Grund von Gatterverzögerungszeiten für das Zwischenspeichern benötigt wird. Durch die Zwischenspeicherschaltung wird eine minimale Impulsdauer des Ausgangsimpulses garantiert, die unabhängig von der Dauer des Eingangssignales ist.

Der erfindungsgemäße Impulserzeuger weist in Reihe geschaltete Invertierglieder, ein logisches Verknüpfungsglied und ein Verzögerungsglied auf. Die dem Verzögerungsglied und dem Eingangsanschluss nachgeschaltete Zwischenspeicherschaltung sorgt dafür, dass auch bei einem Eingangssignal sehr kurzer Dauer eine minimale Impulsdauer eines aus diesem Eingangssignal erzeugten Ausgangsimpulses garantiert ist.

Wesentlich an dem Impulserzeuger ist nun die spezielle Gestaltung des Verknüpfungsgliedes aus einem NOR-Glied und die Führung des Eingangssignales über zwei verschiedene Signalwege, wie diese im kennzeichnenden Teil des Patentanspruches 1 angegeben sind.

Die Erfindung ermöglicht damit einen Impulserzeuger, bei dem auf einfache Weise die maximale Impulsdauer eines Ausgangsimpulses durch die Dauer eines Eingangssignales und die minimale Impulsdauer des Ausgangsimpulses durch die Verzögerungszeit eines Verzögerungsgliedes definiert ist.

Nachfolgend werden Ausführungsbeispiele der Erfindung anhand der Zeichnungen näher erläutert. Es zeigen:
- Figur 1: ein Schaltschema eines Ausführungsbeispiels eines erfindungsgemäßen Impulserzeugers,
- Figur 2: ein Impulsdiagramm zur Erläuterung der Funktion der in Figur 1 dargestellten Impulserzeugerschaltung und
- Figur 3: ein Schaltschema eines weiteren verbesserten Ausführungsbeispiels eines erfindungsgemäßen Impulserzeugers.

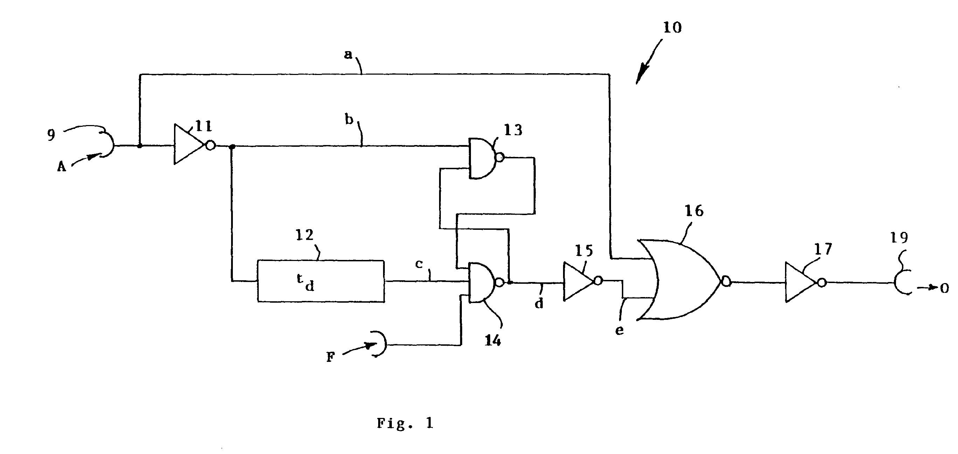

Es sei betont, dass die in Figur 1 dargestellte und in der nachfolgenden Beschreibung erläuterte Impulserzeugerschaltung eine positive sequenzielle Logikschaltung darstellt, die einen Ausgangsimpuls A in Reaktion auf ein Eingangssignal erzeugt, das durch einen positiven Potenzialwechsel von tief nach hoch dargestellt ist. Statt dessen kann, wie jedem Fachmann geläufig ist, auch eine äquivalente Schaltung realisiert werden, die auf einen negativen Signalwechsel eines Eingangssignals einen Ausgangsimpuls erzeugt. Ebenso kann eine erfindungsgemäße Impulserzeugerschaltung mit negativer Logik realisiert werden.

Das in Figur 1 dargestellte und allgemein mit der Bezugszahl 10 bezeichnete Ausführungsbeispiel des erfindungsgemäßen Impulserzeugers weist einen ersten Signalweg a zwischen einem ein Eingangssignal A zuführenden Eingangssignalanschluss 9 und einem ersten Eingang eines durch ein NOR-Glied 16 dargestellten logischen Verknüpfungsglieds mit zwei Eingängen und einen zweiten Signalweg b mit einem das Eingangssignal A invertierenden ersten Invertierglied 11 zwischen dem Eingangsanschluss 9 und einem ersten Eingang einer durch zwei kreuzgekoppelte NAND-Glieder 13, 14 dargestellten Zwischenspeicherschaltung auf.

Das durch das erste Invertierglied 11 invertierte Eingangssignal A wird außerdem parallel an einen Eingang eines Verzögerungsglieds 12 angelegt, dessen Ausgangssignal c einem zweiten Eingangsanschluss der die beiden NAND-Glieder 13, 14 aufweisenden Zwischenspeicherschaltung angelegt ist. Ein dritter Eingang der Zwischenspeicherschaltung 13, 14 ist mit einem von außen zugeführten Freigabesignal F beaufschlagt.

Das Ausgangssignal d der Zwischenspeicherschaltung 13, 14 wird durch ein zweites Invertierglied 15 invertiert und gelangt als Signal e an den zweiten Eingang des NOR-Glieds 16. Dessen Ausgang wird durch ein drittes Invertierglied 17 invertiert, dessen Ausgangssignal direkt als Ausgangssignal O einem Ausgangsanschluss 19 zugeführt wird.

Die Figur 1 zeigt, dass ein durch einen Potenzialwechsel von tief nach hoch dargestelltes Eingangssignal A unvermittelt durch den ersten Eingang des NOR-Glieds 16 zum Ausgangsanschluss 19 übertragen wird und somit die (positive) Vorderflanke des Ausgangsimpulses O der Impulserzeugerschaltung 10 bestimmt. Gleichzeitig liegt über den Signalweg b das durch das erste Invertierglied 11 invertierte Eingangssignal am ersten Eingang des ersten NAND-Glieds 13 der Zwischenspeicherschaltung an und bewirkt, da das Potenzial am zweiten Eingang des ersten NAND-Glieds 13 der Zwischenspeicherschaltung tief liegt, dass der Ausgang dieses NAND-Glieds 13 hoch geht. Dieses hohe Potenzial liegt an einem ersten Eingang des zweiten NAND-Glieds 14 der Zwischenspeicherschaltung an und greift dort durch, sodass der Ausgang des zweiten NAND-Glieds 14 tief geht, sofern die beiden anderen Eingänge des zweiten NAND-Glieds 14 ebenfalls hoch liegen.

Der zweite Eingang des NAND-Glieds 14 bleibt so lange hoch, wie der das Eingangssignal repräsentierende Potenzialwechsel von hoch nach tief noch nicht am Ausgang des Verzögerungsglieds 12 erscheint, und der dritte Eingang des NAND-Glieds 14 liegt hoch, solange das Freigabesignal F hoch liegt und die Impulserzeugerschaltung 10 freigibt. Somit kann unter diesen Bedingungen der Ausgang des NAND-Glieds 14 tief gehen (Signal d) und nach der Inversion durch das zweite Invertierglied 15 als Signal e in Form eines positiven Potenzialwechsels dem zweiten Eingang des NOR-Glieds 16 anliegen.

Dies bedeutet, dass sich der tiefe Zustand "0" am Ausgang des NOR-Glieds 16 und damit der hohe Zustand des Ausgangsimpulses O am Ausgangsanschluss 19 mindestens so lange halten, wie das Eingangssignal e am zweiten Eingang des NOR-Glieds 16 hoch bleibt.

Dieses Signal e bleibt aber, wie die vorangehende Beschreibung deutlich macht, solange hoch, bis der das Eingangssignal A repräsentierende Potenzialwechsel durch das Verzögerungsglied 12 gelaufen ist, d. h., wenn das dem zweiten Eingang des zweiten NAND-Glieds 14 anliegende Signal c tief geht. Dann geht das Signal d hoch, das Signal e geht tief, der Ausgang des NAND-Glieds 16 geht hoch und das Ausgangssignal O geht tief, wenn nicht das Eingangssignal A, welches durch den ersten Signalweg a dem ersten Eingang des NOR-Glieds 16 anliegt, noch hoch bleibt.

Die maximale Impulsdauer des Ausgangsimpulses O ist somit durch die Dauer des Eingangssignals A festgelegt und die minimale Impulsdauer des Ausgangssignals ist durch die Verzögerungszeit t_{d} des Verzögerungsglieds 12 definiert.

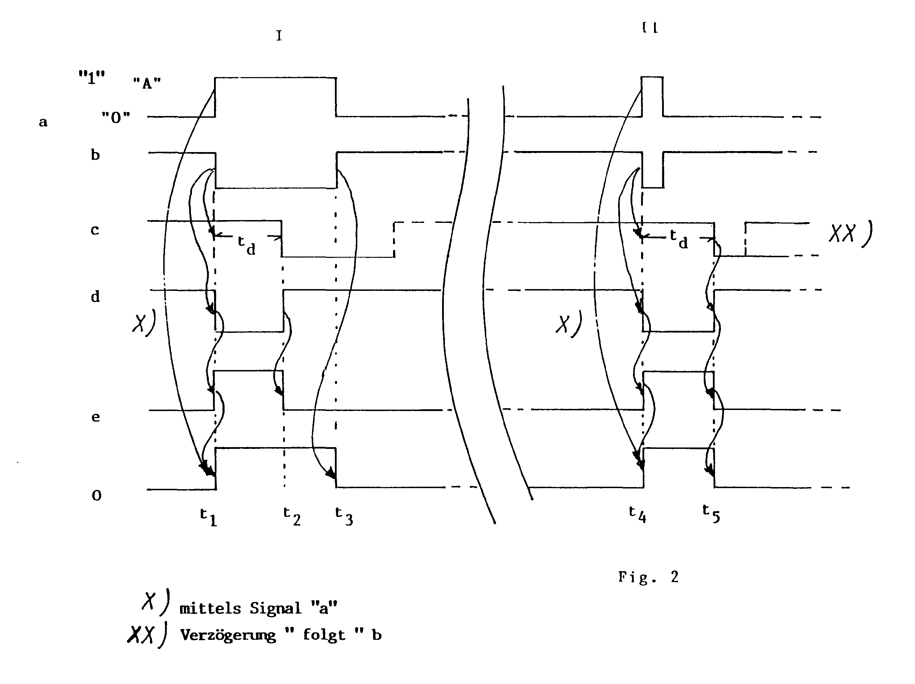

Figur 2 zeigt in Form eines Impulsdiagramms die oben in Worten erläuterte Funktionsweise des in Figur 1 gezeigten Ausführungsbeispiels des erfindungsgemäßen Impulserzeugers, und zwar im linken Abschnitt I für ein Eingangssignal A längerer Dauer und im rechten Abschnitt II für ein Eingangssignal A kürzerer Dauer.

Die erste Zeile in Figur 2 zeigt eine beispielhafte Signalform für das Eingangssignal A am Eingangsanschluss 9 und auf dem Signalweg a. Zum Zeitpunkt t₁ trifft die Vorderflanke des Eingangssignals A am Eingangsanschluss 9 ein, d. h., das Eingangssignal A erfährt einen Potenzialwechsel von tief nach hoch, der bis zum Zeitpunkt t₃ hoch bleibt.

Die zweite Zeile zeigt den Signalverlauf des vom ersten Invertierglied 11 invertierten Eingangssignals auf dem zweiten Signalweg b, das auch an dem Eingang des Verzögerungsglieds 12 anliegt. Die dritte Zeile zeigt das um t_{d} verzögerte Signal c am Ausgang des Verzögerungsglieds 12 (Zeitpunkt t₂). Die vierte Zeile zeigt das am Ausgang der Zwischenspeicherschaltung 13, 14 erscheinende Signal d. Die fünfte Zeile zeigt das durch das zweite Invertierglied 15 invertierte Signal e. Die sechste Zeile zeigt den Ausgangsimpuls O.

Figur 2 zeigt in der sechsten Zeile des Abschnitts I, dass bei einem länger dauernden Eingangssignal A der Ausgangsimpuls O eine mit der Dauer des Eingangssignals A übereinstimmende Impulsdauer hat. "Länger" bedeutet dabei länger als die Verzögerungszeit t_{d} des Verzögerungsglieds 12. Dies rührt daher, da das nach Ablauf der Verzögerungszeit t_{d} des Verzögerungsglieds 12 (Signal c) zum Zeitpunkt t₂ hoch gehende Signal d am Ausgang der Zwischenspeicherschaltung 13, 14 und damit das auf Grund der Inversion durch das zweite Invertierglied 15 tief gehende Signal e nicht durch das NOR-Glied 16 durchgreifen kann, weil das Potenzial an dessen erstem Eingang auf Grund des länger dauernden Eingangssignals A über den ersten Signalweg a immer noch hoch liegt. Somit ist im Beispiel des Abschnitts I die Rückflanke des Ausgangsimpulses O durch die Dauer des Eingangssignals A bestimmt (Zeitpunkt t₃).

In dem in der rechten Hälfte der Figur 2 gezeigten Beispiel II erscheint zum Zeitpunkt t₄ erneut ein Eingangssignal A am Eingangsanschluss 9, dessen Dauer jedoch sehr viel kürzer ist als das Eingangssignal im linken Abschnitt I der Figur 2 und auch kürzer als die Verzögerungszeit t_{d} des Verzögerungsglieds 12.

Wie schon erläutert wurde, ist in diesem Fall für die Dauer des Ausgangsimpulses O die durch das Verzögerungsglied 12 verursachte Verzögerungszeit, d. h. das Zurücksetzen der Zwischenspeicherschaltung 13, 14 (zum Zeitpunkt t₅), maßgeblich, sodass hier der Fall nicht auftreten kann, dass ein zu kurzes Eingangssignal A keinen oder einen undefinierten Ausgangsimpuls O am Ausgangsanschluss 19 erzeugt, wie dies in der eingangs beschriebenen herkömmlichen Impulserzeugerschaltung auftreten konnte.

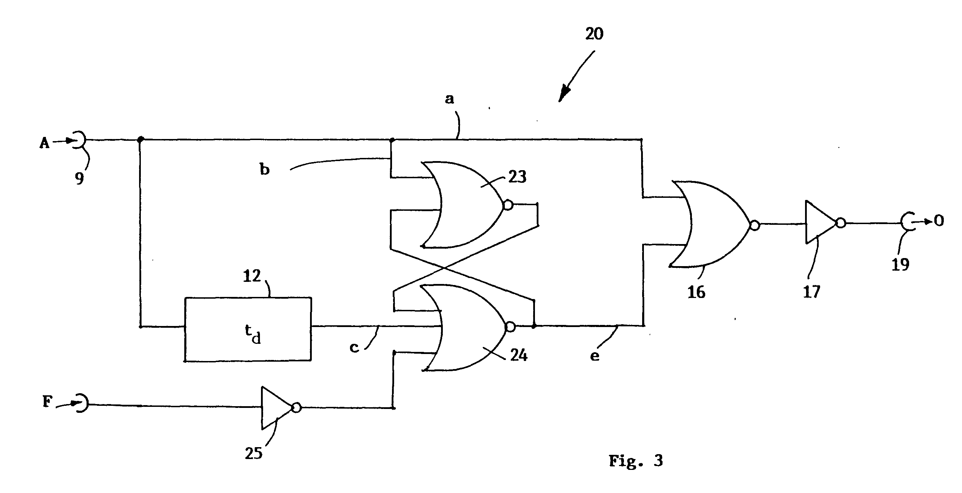

Die Figur 3 zeigt ein hinsichtlich der Anzahl der Bauelemente und der Geschwindigkeit des Zwischenspeichervorgangs optimiertes Ausführungsbeispiel einer Impulserzeugerschaltung 20, bei der die die Zwischenspeicherschaltung bildenden kreuzgekoppelten NAND-Glieder gemäß Figur 1 durch kreuzgekoppelte NOR-Glieder 23, 24 ersetzt sind. Wie Figur 3 zeigt, fallen die Signalwege a und b zusammen, sodass das Eingangssignal A vor seiner Zwischenspeicherung nicht invertiert wird und die Laufzeit des Invertierglieds 11 eingespart wird. Funktionell ist die Schaltung in Figur 3 jedoch identisch mit der in Figur 1, sodass sich eine spezielle Beschreibung hierfür erübrigt, da die wesentlichen Funktionen bereits anhand der Figuren 1 und 2 erläutert wurden.

## Patentansprüche

1. Impulserzeuger (10), insbesondere in bzw. für integrierte(n) Schaltungen, bei dem Invertierglieder (11, 15, 17) mit anderen Schaltungskomponenten in Serie geschaltet sind und der ein logisches Verknüpfungsglied (16) und ein Verzögerungsglied (12) an einem Eingang des Verknüpfungsglieds (16) aufweist, um aus einem an einem Eingangsanschluss (9) anliegenden Eingangssignal (A) ein impulsförmiges Ausgangssignal (O) definierter Impulsdauer zu erzeugen, wobei in Reihe zum Verzögerungsglied (12) eine Zwischenspeicherschaltung (13, 14; 23, 24) geschaltet ist, die vom Eingangssignal (A) praktisch unverzögert gesetzt und nach Ablauf einer durch das Verzögerungsglied (12) bestimmten Zeitdauer oder, wenn das Eingangssignal (A) später abklingt, zum Zeitpunkt des Abklingens desselben zurückgesetzt wird, so dass auch ein Eingangssignal (A) kürzerer Dauer als die Verzögerungszeit (td) des Verzögerungsglieds (12) zu einem Ausgangsimpuls (O) mit definierter Mindestimpulsdauer führt,
**dadurch gekennzeichnet,** dass
das Eingangssignal (A) über einen ersten Signalweg (a) unmittelbar einem ersten Eingang eines NOR-Glieds (16), welches das logische Verknüpfungsglied ist, über einen zweiten Signalweg (b) einem ersten Eingang der Zwischenspeicherschaltung (13, 14; 23, 24) und gleichzeitig einem Eingang des Verzögerungsglieds (12) zugeführt wird, dessen Ausgang einem zweiten Eingang der Zwischenspeicherschaltung (13, 14) angelegt ist,
der Ausgang der Zwischenspeicherschaltung (13, 14) einem zweiten Eingang des NOR-Glieds (16) zugeführt wird, und
der Ausgang des NOR-Glieds (16) durch ein Invertierglied (17) invertiert dem Ausgangsanschluss (19) als das Ausgangssignal (O) zugeführt wird.

2. Impulserzeuger nach Anspruch 1,
**dadurch gekennzeichnet,** dass
die Zwischenspeicherschaltung (13, 14) zwei kreuzgekoppelte NAND-Glieder aufweist.

3. Impulserzeuger nach Anspruch 1,
**dadurch gekennzeichnet,** dass
die Zwischenspeicherschaltung (23, 24) zwei kreuzgekoppelte NOR-Glieder aufweist.

4. Impulserzeuger nach einem der Ansprüche 1 bis 3,
**dadurch gekennzeichnet,** dass
das Eingangssignal (A) durch einen Potentialwechsel von Tief nach Hoch dargestellt ist und das Ausgangssignal (O) des Impulserzeugers (10) ein positiver Impuls ist, so dass eine flankenmäßig richtungsgleiche Signalwandlung vorliegt.

5. Impulserzeuger nach einem der vorangehenden Ansprüche,
**dadurch gekennzeichnet,** dass
die Zwischenspeicherschaltung (13, 14; 23, 24) ferner einen als Freigabeeingang dienenden dritten Eingang aufweist, dem ein Freigabesignal (F) zuführbar ist.
